# EUROPEAN PATENT APPLICATION

(11) **EP 1 753 017 A1**
(43) Date of publication of application: **14.02.2007**
(21) Application number: 05734493.9
(22) Date of filing: 25.04.2005
(51) Int. Cl.: H01L 21/027, G03F 7/20

(54) **ANALYSIS METHOD, EXPOSING EQUIPMENT AND EXPOSING EQUIPMENT SYSTEM**

(30) Priority: 28.04.2004 JP 2004133600
(71) Applicant: NIKON CORPORATION, Tokyo 100-8331 (JP)
(72) Inventor: Shiraishi, Kenichi, Nikon Corp. IP Dept., Tokyo 1008331 (JP)
(74) Representative: Wiebusch, Manfred
(86) International application number: PCT/JP2005/007807
(87) International publication number: WO 2005/106932

(57) **Abstract**

The present invention provides a method of analysis enabling easy and suitable analysis of measurement data relating to the production of devices and dependent on the recipe or combination of processing units. According to the method, for example the line width precision, overlay precision, and other characteristics of the results of exposure are detected from the results of exposure for different lots and those characteristics are classified linked with for example the recipes at the time of the exposure processing exhibiting those characteristics and the processing units or combinations thereof in the exposure apparatus or track. Further, based on the classified results, whether the characteristics of the results of exposure are dependent on the specific recipe or processing units is judged. When there is dependency, when a lot using that recipe or processing unit is subsequently loaded, a warning is issued or automatic correction is performed to prevent processing with poor precision.

## Description

### TECHNICAL FIELD

The present invention relates to a method of analysis, suitable for use when producing for example a semiconductor device, liquid crystal display device, CCD or other image capturing device, plasma display device, thin film magnetic head, or other electronic device (hereinafter simply referred to as "electronic device" or "device"), which is able to analyze data relating to results of exposure and detect early the deterioration of the line width control precision or overlay precision. Further, it relates to an exposure apparatus and exposure apparatus system able to use the method of analysis for the early detection of deterioration of the line width control precision and overlay precision and able to improve the productivity of the electronic device.

### BACKGROUND ART

In the production of an electronic device, the lithography step uses an exposure apparatus to project and expose the images of fine patterns formed on a photomask or reticle (hereinafter referred to all together as a "reticle") on a semiconductor wafer, glass plate, or other substrate (hereinafter referred to as a "wafer") on which a photoresist or other photosensitive agent is coated. At that time, it positions (aligns) the reticle and the wafer with a high precision and overlays and projects and exposes patterns of the reticle on patterns already formed on the wafer. In recent years, there have been rapid advances made in increasing the fineness of patterns and increasing the degree of integration. Such exposure apparatuses are therefore being required to enable even higher exposure precision than in the past. For this reason, there have been increasingly greater demands on the precision of alignment. Higher precision alignment is now being required.

As a method for mark detection in reticle alignment, the method using exposure light may be said to be the most general. The method of irradiating exposure light on an alignment mark formed on the reticle, using a CCD camera etc. to capture an image of the alignment mark, and processing the image data to measure the mark position, that is, the VRA (visual reticle alignment) method, etc. are being used. As a method for mark detection in wafer alignment, there is the method of focusing a laser beam on a dot-array alignment mark of the wafer and using the light diffracted or scattered by the mark to measure the mark position, that is, the LSA (laser step alignment) method. Further, there is the method of irradiating light of a broad wavelength band using a halogen lamp etc. as a light source on an alignment mark, using a CCD camera etc. to capture an image of the alignment mark, and processing the image data to measure the mark position, that is, the FIA (field image alignment) method. Further, there are the method of irradiating a grating grid alignment mark on a wafer by laser beams differing slightly in frequency from two directions, causing interference between the two generated diffraction lights, and measuring the position of the alignment mark from the phase, that is, the LIA (laser interferometric alignment) method, etc.

For wafer alignment, there are the method of detecting an alignment mark for positioning for each shot area of a wafer, that is, the die-by-die (D/D) alignment method, and the method of detecting alignment marks for several shot areas of a wafer to find the regularity of the array of the shot areas and thereby position the shot areas, that is, the global alignment method. In the production lines for electronic devices, at the present, the global alignment method is mainly being used in view of the balance with the throughput. Particularly, recently, the method of detecting the regularity of the array of shot areas on a wafer with a higher precision by statistical techniques, that is, the enhanced global alignment (EGA) method, is being widely used (for example, see Japanese Patent Publication ((A) No. 62-84516). These optical type alignment methods first detect alignment marks on the reticle and measure their positional coordinates. Next, they detect alignment marks on the wafer and measure their positional coordinates. Next, they find the relative positional relationships of the positions of the reticle and the positions of the overlaid shots from these measurement results. Based on these results, they make the pattern images of the reticle overlay the shot positions by moving the wafer by the wafer stage and then project the pattern images of the reticle for exposure.

Further, large numbers of types of electronic devices are required to be produced in short periods of time, so improvements in productivity are also being sought. Therefore, to enable trouble in production to be quickly detected and quickly dealt with on production lines of electronic devices and further to thereby enable devices with excellent characteristics to be produced efficiently and, in turn, improve the operating rates of the apparatuses and raise the yield, information collection/analysis apparatuses, diagnosis systems, apparatus support systems, etc. are being introduced. Such diagnosis systems or apparatus support systems collect various types of data from exposure apparatuses, process processing apparatuses, and other production apparatuses, inspection apparatuses, measurement apparatuses, etc. Server apparatuses etc. analyze these data to obtain a grasp of the conditions and adjust control parameters etc. By this, for example, it is possible to analyze and obtain a grasp of the operating states of apparatuses, statistically analyze the trends in apparatuses to detect abnormalities, predict the future from the trends in the apparatuses to prevent the occurrence of abnormalities, etc. (for example, see Japanese Patent No. 336436).

However, in the lithography step, specific errors sometimes become greater in specific processes. For example, when using a certain process program (sometimes also called a "recipe") to expose a first layer of patterns in a lot, then exposing a second layer of exposure, the nonlinear components of the EGA measurement result become larger and the overlay precision is detrimentally affected or the focus control precision deteriorates in partial shots covering the wafer edges in only the wafers of specific processes. In general, when running lots through an exposure apparatus, it is necessary to prepare a recipe for each process and optimize the parameters in the recipe for the process. However, optimizing all of the parameters in a recipe for each process would be extremely difficult due to the large number of the parameters. Therefore, wafers are not necessarily exposed under the optimum recipe settings in practice. It is believed that specific errors become worse in specific recipes due to this.

On the other hand, when a track is provided with a plurality of units of the same functions in the coating, baking, cooling, developing, and other modules, sometimes a difference arises in the line width control precision or overlay precision due to the combination of the units actually used. In the same way as when an exposure apparatus is provided with a plurality of stages, exposure units, and alignment systems, when using a specific unit or a specific combination of the same, the nonlinear components of the EGA become greater and the line width control precision or overlay precision is detrimentally affected in some cases. This problem is very likely to cause variations in performance of the electronic devices or lower yield. Detecting this as early as possible and quickly making corrections or taking countermeasures is important from the viewpoint of improvement of the productivity and improvement of the quality.

Therefore, an object of the present invention is to provide a method of analysis enabling easy and suitable analysis of the line width control precision, overlay precision, or other measurement data relating to the production of a device and dependent on the process program (recipe) and processing unit or combination of the same in the lithography step. Another object of the present invention is to provide an exposure apparatus and exposure apparatus system able to suitably perform analysis by such a method of analysis and suitably produce electronic devices with a high productivity.

### DISCLOSURE OF THE INVENTION

According to a first aspect of the present invention, there is provided a method of analysis comprising detecting predetermined characteristics of results of exposure obtained by exposure of an exposure object (step S110), detecting process programs defining conditions of predetermined processing of a lithography step including said exposure performed on said exposure object (step S120), classifying the detected predetermined characteristics of results of exposure for each said process program (step S130), and detecting dependency of said predetermined characteristics of results of exposure on said process programs.

This method of analysis detects for example the line width precision, overlay precision, and other characteristics of the results of exposure from the results of the exposure processing and classifies those characteristics linked with the process programs (recipes) which is used at the time of performing the exposure processing exhibiting those characteristics. Due to this, it is possible to compare the characteristics of the results of exposure for each recipe and as a result detect the relationship and correlation of those characteristics and recipes, that is, the dependency of those characteristics on the recipes.

In the method of analysis according to the first aspect of the present invention, it is possible to detect a processing unit or combination of processing units used for predetermined processing of said lithography step performed on said exposure object, classify said detected predetermined characteristics of results of exposure for each said process program, said processing unit, said combination of processing units, or combination thereof, and detect dependency of said predetermined characteristics of results of exposure on each said process program, said processing unit, said combination of processing units, or combination thereof. As a preferable specific example, said predetermined characteristics of results of exposure are a precision of line width of patterns formed by exposure and an overlay precision of said patterns.

In the method of analysis according to the first aspect of the present invention, it is possible to specify at least one of said process program, said processing unit, said combination of processing units, or combination thereof where said predetermined characteristics of results of exposure are predicted to exceed predetermined reference values based on said detected dependency and issue a warning when processing relates to said specified process program, processing unit, combination of processing units, or combination thereof.

According to a second aspect of the present invention, there is provided a method of analysis comprising detecting predetermined characteristics of results of exposure obtained by exposure of an exposure object, detecting processing units or combinations of processing units used for predetermined processing of a lithography step performed on said exposure object, classifying said detected predetermined characteristics of results of exposure for each said processing unit or combination of processing units, and detecting dependency of said predetermined characteristics of results of exposure on each said process program.

According to a third aspect of the present invention, there is provided an exposure apparatus comprising an exposing portion for exposing patterns formed on a mask onto a substrate, a detecting portion for detecting predetermined characteristics of results of exposure of said patterns, a collecting portion for collecting process programs defining conditions of processing used in predetermined processing of a lithography step including said exposure for said substrate used for said exposure, processing units or combinations of processing units used in said predetermined processing of said lithography step, or their combinations, and an analyzing portion for classifying said predetermined characteristics of results of exposure detected by said detecting portion for each of said process programs, said processing units, said combinations of processing units, or their combinations collected by said collecting portion and analyzing dependency of said predetermined characteristics of results of exposure on said process programs, said processing units, said combinations of processing units, and combinations thereof.

According to the exposure apparatus according to the third aspect of the present invention, said analyzing portion may issue a warning that a substrate to be exposed is a substrate on which a process program, processing unit, combination of processing units, or their combination which would have an effect on the predetermined characteristics of results of exposure is used when this is the case. Further, said exposing portion may perform exposure along with correction processing for eliminating effects on said predetermined characteristics when the substrate to be exposed is a substrate on which a process program, processing unit, combination of processing units, or their combination which would have an effect on the predetermined characteristics of results of exposure is used.

According to a fourth aspect of the present invention, there is provided an exposure apparatus system (1) comprising a track (20) having processing units for performing predetermined processing of steps before and after exposure on a substrate used for exposure, an exposure apparatus (10) for transferring patterns formed on a mask to a predetermined shot area of a substrate by exposure processing, a collecting portion (20) for collecting process programs defining conditions of processing used in predetermined processing of a lithography step including said exposure for said substrate used for said exposure, processing units or combinations of processing units used in said predetermined processing of said lithography step. or their combinations, and an analyzing apparatus (251) for classifying said predetermined characteristics of results of exposure for each of said process programs, said processing units, said combinations of processing units, or their combinations collected by said collecting portion and analyzing dependency of said predetermined characteristics of results of exposure on said process programs, said processing units, said combinations of processing units, or combinations thereof.

In the exposure apparatus system according to the fourth aspect of the present invention, said track (20) may further have an optimal condition detecting portion for detecting control conditions for processing of a substrate, on which a process program, processing unit, combination of processing units, or their combination which would have an effect on the predetermined characteristics of results of exposure is used, by said exposure apparatus so that said predetermined characteristics are not affected, and said exposure apparatus (10) may perform exposure by said control conditions detected by said optimal condition detecting portion when the substrate to be exposed is a substrate on which a process program, processing unit, combination of processing units, or their combination which would have an effect on the predetermined characteristics of results of exposure is used. Further, said optimal condition detecting portion may measure surface relief of said substrate and detect said control conditions for focus control. Further, said optimal condition detecting portion may observe patterns formed on said substrate and detect said control conditions for detection of the positions of said patterns.

Note that the notations attached to some of the parts in this section are notations of corresponding parts shown in the attached drawings, but these are only for facilitating understanding and do not in any way indicate that the means of the present invention are limited to the embodiments explained later with reference to the attached drawings.

According to the method of analysis according to the first or second aspect of the present invention, it becomes possible to easily and suitably analyze line width control precision, overlay precision, and other measurement data relating to device production dependent on the process program (recipe) or processing unit or combination thereof in the lithography step. Further, according to the exposure apparatus of the third aspect of the present invention or the exposure apparatus system according to the fourth aspect, it is possible to produce electronic devices suitably and with a high productivity.

### BRIEF DESCRIPTION OF THE DRAWINGS

FIG. 1 is a view of the configuration of an exposure apparatus system of an embodiment of the present invention,
FIG. 2 is a view of the configuration of an exposure apparatus of an exposure apparatus system shown in FIG. 1,
FIG. 3 is a cross-sectional view of an indicator plate of an off-axis type alignment optical system of the exposure apparatus shown in FIG. 1,
FIG. 4 is a view of the configuration of the functions of a server of the exposure apparatus system shown in FIG. 1,
FIG. 5 is a view of an error count graph of an apparatus/process analysis function of the functions of the server shown in FIG. 4,
FIG. 6 is a view of a productivity graph of an apparatus/process analysis function of the functions of the server shown in FIG. 4,
FIG. 7 is a view of an apparatus environment graph of an apparatus/process analysis function of the functions of the server shown in FIG. 4,
FIG. 8 is a schematic view of the configuration of processing units of the exposure apparatus and track shown in FIG. 1,
FIG. 9 is a flow chart of a method of analysis according to the present invention in the exposure apparatus system shown in FIG. 1, and
FIG. 10 is a view of the distribution of EGA nonlinear components by recipe.

### BEST MODE FOR CARRYING OUT THE INVENTION

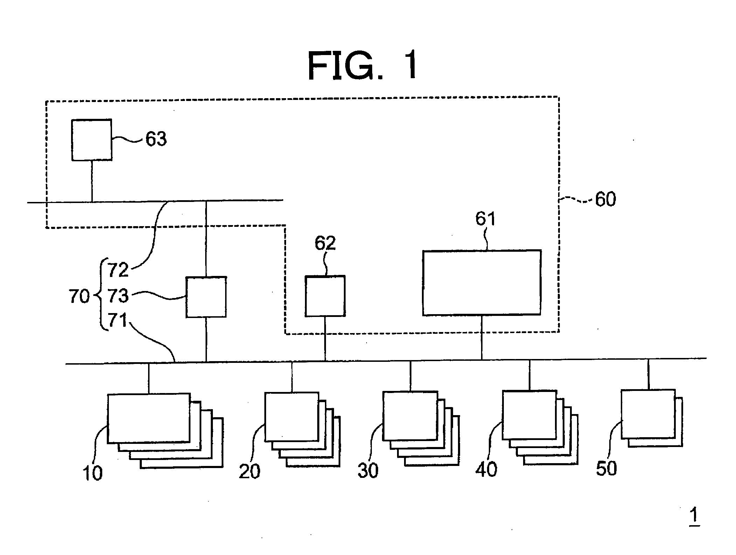

Embodiments of the present invention will be explained with reference to FIG. 1 to FIG. 10. FIG. 1 is a block diagram showing the configuration of an exposure apparatus system 1 of an embodiment of the present invention. As shown in FIG. 1, the exposure apparatus system 1 has an exposure apparatuses 10, tracks 20, lasers 30, in-line measuring devices (inspection apparatuses) 40, off-line measuring devices (inspection apparatuses) 50, an apparatus support system 60, and a communication network 70.

The apparatus support system 60 has a server 61, terminal apparatus 62, and remote terminal apparatus 63. Further, the communication network 70 has a first network 71, second network 72, and gate apparatus 73. Note that the exposure apparatus system 1 has a plurality of device production lines. The pluralities of exposure apparatuses 10, tracks 20, lasers 30, and in-line measuring devices 40 are for example provided corresponding to the lines. Further, the plurality of the off-line measuring devices 50 are provided separate from these production lines.

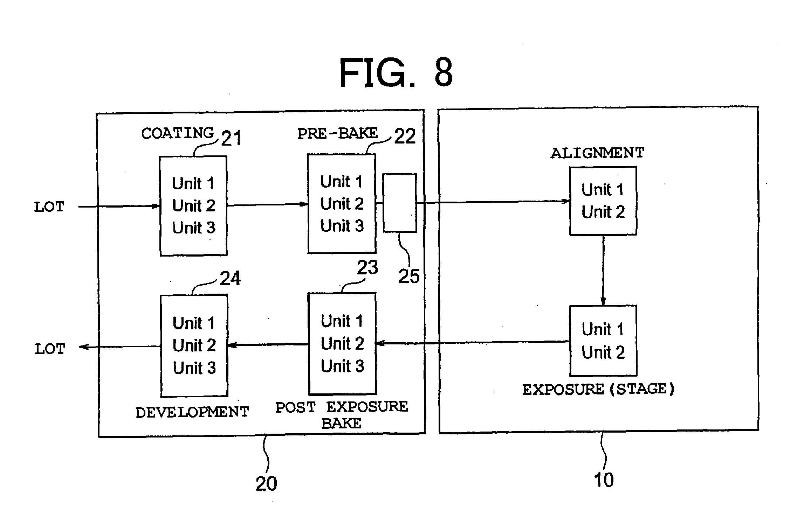

First, the configuration of the parts of the exposure apparatus system 1 will be successively explained. Each exposure apparatus 10 projects images of the desired patterns formed on a reticle to a substrate (wafer) on which a photosensitive material is coated and transfers the patterns on the wafer. The exposure apparatus 10 of the present embodiment, as shown in FIG. 8, is an exposure apparatus of a so-called twin-stage type provided with two wafer stages carrying wafers and further two alignment systems for wafer alignment. The wafer carried on the first stage is aligned by the first aligment unit, then placed on the exposure apparatus under the projection optical system for the first stage and exposed. Further, the wafer carried on the second stage is aligned by the second alignment unit, then placed on the exposure apparatus under the projection optical system for the second stage and exposed. The alignment of the wafer of the first stage by the first alignment unit and the exposure processing of the wafer of the second stage by the projection optical system and the exposure processing of the wafer of the first stage by the projection optical system and the alignment of the wafer of the second stage by the second alignment unit are performed alternately simultaneously in parallel, whereby efficient exposure processing is possible. Note that these two stage units and two alignment units are configured the same, so in the following explanation of the configuration of the exposure apparatus, just one of each will be illustrated and explained.

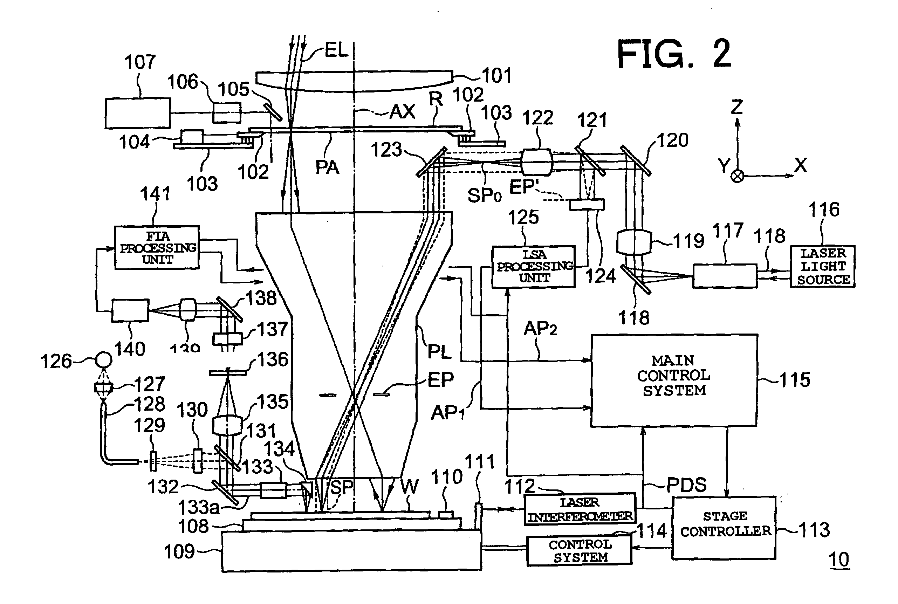

The overall configuration of each exposure apparatus will be explained with reference to FIG. 2 to FIG. 3. Note that in the following explanation, an XYZ Cartesian coordinate system shown in FIG. 2 is set. This XYZ Cartesian coordinate system will be referred to for the explanation of the positional relationship etc. of the different members. In the XYZ Cartesian coordinate system, the X-axis and Z-axis are set parallel to the paper surface and the Y-axis is set in a direction perpendicular to the paper surface. In the XYZ coordinate system in the figures, the XY plane is actually set to a plane parallel to the horizontal plane and the Z-axis is set in the vertical direction.

In each exposure apparatus 10, as shown in FIG. 2, a not shown illumination optical system emits exposure light EL through a condenser lens 101 to a pattern area PA formed on a reticle R by a uniform illumination distribution. As the exposure light EL, for example, g-rays (436 nm) or i-rays (365 nm) or light emitted from a KrF excimer laser (248 nm), ArF excimer laser (193 nm), or F2 laser (157 nm) is used.

The reticle R is held on a reticle stage 102. The reticle stage 102 is supported to be able to move and finely rotate on a 2D plane on a base 103. A main control system 115 controlling the apparatus as a whole controls the operation of the reticle stage 102 through a drive apparatus 104 on the base 103. This reticle R is positioned with respect to an optical axis AX of the projection optical system PL by detection by not shown reticle alignment marks formed at its periphery by a reticle alignment system comprised of a mirror 105, object lens 106, and mark detection system 107.

Exposure light EL passed through the pattern area PA of the reticle R strikes for example a two-sided (or one-sided) telecentric projection optical system PL and is projected on individual shot areas on a wafer (substrate) W. The projection optical system PL is corrected for aberration best for the wavelength of the exposure light EL. Under that wavelength, the reticle R and the wafer W are conjugated. Further, the exposure light EL is Koehler illumination and is focused as a light source at the center of a pupil EP of the projection optical system PL. Note that projection optical system PL has a plurality of lenses and other optical devices. These optical devices are made from quartz, fluorite, and other optical materials in accordance with the wavelength of the exposure light EL.

The wafer W is placed via a wafer holder 108 on a wafer stage 109. The wafer holder 108 is provided with reference marks 110 used in baseline measurement etc. The wafer stage 109 has an XY stage for positioning two-dimensionally the wafer W in a plane perpendicular to the optical axis AX of the projection optical system PL, a Z-stage for positioning the wafer W in a direction parallel to the optical axis AX of the projection optical system PL (Z-direction), a stage finely rotating the wafer W about the Z-axis, a stage changing an angle with respect to the Z-axis to adjust an inclination of the wafer W with respect to the XY plane, etc.

At one end of the top surface of the wafer stage 109 is attached an L-shaped moving mirror 111. A laser interferometer unit 112 is provided at a position facing the mirror surface of the moving mirror 111. While shown simplified in FIG. 2, the moving mirror 111 is comprised of a flat mirror having a reflection surface perpendicular to the X-axis and a flat mirror having a reflection surface perpendicular to the Y-axis. Further, the laser interferometer unit 112 is comprised of two X-axis laser interferometers emitting laser beams along the X-axis to the moving mirror 111 and a Y-axis laser interferometer emitting a laser beam along the Y-axis to the moving mirror 111. One X-axis laser interferometer and the single Y-axis laser interferometer measured the X-ooordinate and Y-ooordinate of the wafer stage 109. Further, the difference in measurement values of the two X-axis laser interferometers is used for measurement of the rotational angle of the wafer stage 109 in the XY plane.

A position detection signal PDS of the X-coordinate, Y-coordinate, and rotational angle measured by the laser interferometer unit 112 is supplied to a stage controller 113. The stage controller 113 controls the position of the wafer stage 109 in accordance with this position detection signal PDS through a drive system 114 under the control of the main control system 115. Further, the position detection information PDS is output to the main control system 115. The main control system 115 monitors the supplied position detection signal PDS and outputs a control signal for controlling the position of the wafer stage 109 to the stage controller 113. Further, the position detection signal PDS output from the laser interferometer unit 112 is output to a later explained field image alignment (FIA) processing unit 141.

Note that the exposure apparatus shown in FIG. 2 has a TTL type of alignment system (116, 117, 118, 119, 120, 121, 122, 123, and 124), but the explanation will be omitted here. The exposure apparatus 10 is provided with an off-axis type alignment optical system (hereinafter referred to as "alignment sensor") at the side of the projection optical system PL. This alignment sensor is a FIA (field image alignment) type alignment sensor which processes a signal capturing the vicinity of alignment marks of the substrate surface (n-dimension signal) (including image processing) and detects position information of the marks.

In the exposure apparatus 10, this alignment sensor performs search alignment measurement and fine alignment measurement. The search alignment measurement is processing for detecting a plurality of search alignment marks formed on a wafer to detect an amount of rotation of the wafer or positional deviation in the XY plane. In the present embodiment, as the signal processing method for the search alignment measurement, the template matching method using a preset reference pattern (template) to detect predetermined patterns corresponding to the template is used.

Further, the fine alignment measurement is processing for detecting alignment marks for fine alignment formed corresponding to the shot areas and finally positioning each exposure shot. As the image processing method for fine alignment in the present embodiment, the technique of extracting the edge of a mark and detecting its position (edge measurement technique) is used. Note that in both search alignment measurement and fine alignment measurement, the image processing method is not limited to the technique of the present embodiment. Each may be by the template matching or the edge measurement technique or by another image processing method. The observation power at the time of the above search alignment measurement and the observation power at the time of the fine alignment measurement may be equal observation powers. Alternatively, the power at the time of fine alignment may be set to a higher power than the power at the time of search alignment.

This alignment sensor has a halogen lamp 126 for emitting illumination light for illuminating the wafer W, a condenser lens 127 for condensing illumination light emitted from a halogen lamp 126 to one end of an optical fiber 128, and an optical fiber 128 for guiding the illumination light. The light source of the illumination light is made a halogen lamp 126 because a halogen lamp 126 emits illumination light of a wavelength of 500 to 800 nm. This is a wavelength region not sensitizing the photoresist coated on the wafer W surface, so the wavelength band is broad and the effects of the wavelength characteristics of the reflectance at the wafer W surface can be reduced.

The illumination light emitted from the optical fiber 128 passes through a filter 129 cutting the photosensitive wavelength (short wavelength) region of the photoresist coated on the wafer W and infrared wavelength region and through a lens system 130 to reach a half mirror 131. The illumination light reflected at the half mirror 131 is reflected by a mirror 132 substantially parallel to the X-axis direction, strikes an object lens 133, is reflected at a prism (mirror) 34 fixed at the periphery of the bottom of a mirror barrel of the projection optical system PL so as not to block the field of the projection optical system PL, and irradiates the wafer W perpendicularly.

Note that while not shown, in the middle of the light path from the emitting end of the optical fiber 128 to the object lens 133, a suitable illumination field stop is provided at a conjugate position with the wafer W for the object lens 133. Further, the object lens 133 is set in a telecentric system. At the plane 133a of the aperture stop (same as pupil), an image of the emitting end of the optical fiber 128 is formed for Koehler illumination. The optical axis of the object lens 133 is set so as to be perpendicular on the wafer W so that at the time of mark detection, no deviation of the mark position due to tilting of the optical axis occurs.

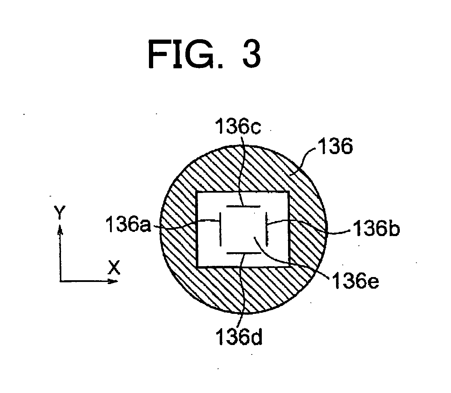

Light reflected from the wafer W passes through the prism 134, object lens 133, mirror 132, and half mirror 131 and is form as an image by the lens system 135 on the indicator plate 136. This indicator plate 136 is arranged conjugate with the wafer W by the object lens 133 and lens system 135 and has straight line indicator marks 136a, 136b, 136c, and 136d extending in the X-axis direction and the Y-axis direction in a rectangular transparent window as shown in FIG. 3. Therefore, images of the marks of the wafer W are formed in the transparent window 136e of the indicator plate 136. The images of the marks of the wafer W and the images of the indicator marks 136a, 136b, 136c, and 136d are formed via relay systems 137 and 139 and a mirror 138 on an image sensor 140.

The image sensor 140 (optoelectric converting means and optoelectric conversion device) converts images striking its image capturing surface to an optoelectric signal (image signal, image data, data, signal). For example, a 2D CCD is used. The signal (n-dimension signal) output from the image sensor 140 is input to an FIA processing unit 141 together with the positional detection signal PDS from the laser interferometer unit 112.

Note that the present embodiment obtains a 2D image signal from the image sensor 140 and inputs it to the FIA processing unit 141 for use. Further, at the time of template matching performed at the time of search alignment, it cumulatively adds (projects) the signal obtained by the 2D CCD in the non-measurement direction and uses the result as a 1D projection signal for measurement in the measurement direction. Note that the format of the signal obtained by the image sensor 140 or the signal for processing at the time of the later signal processing is not limited to the example of the present embodiment. At the time of template matching, it is also possible to perform 2D image processing and use the 2D signal for measurement. Further, it is possible to obtain a 3D image signal and perform 3D image processing. Explaining this further, it is possible to develop the CCD signal in n-dimensions (n being an integer of n≥1) to, for example, generate an n-dimension cosine component signal, n-dimension sine signal, or n-frequency signal etc. and use the n-dimension signal for the position detection. Note that in the explanation of this Description, when referring to an "image", "image signal", "image information", "pattern signal", etc., this similarly includes not only a 2D image, but also such an n-dimension signal (n-dimension image signal or a signal developed from the image signal as explained above).

The FIA processing unit 141 detects an alignment mark from the input image signal and finds the deviation of the mark image of the alignment mark from the indicator marks 136a to 136d. Further, it outputs information AP2 regarding the mark center detection position of the wafer stage 109 when the image of the mark formed on the wafer W is accurately positioned at the center of the indicator marks 136a to 136d from the stop position of the wafer stage 109 expressed by the position detection signal PDS.

The FIA processing unit 141 detects the position of a predetermined alignment mark image and detects its deviation both at the time of search alignment and fine alignment. The present embodiment detects the position of the mark and detects its deviation utilizing the template matching technique at the time of search alignment and utilizing the edge detection processing technique at the time of fine alignment.

The components of each exposure apparatus 10 operate under the control of the main control system 115. The main control system 115 in this way controls the parts of exposure apparatus 10. Further, the main control system 115 communicates through the communication network 70 with the server 61 of the later explained apparatus support system 60. Further, it sends the operation history data, process program (process condition data, also called "recipe" in some cases), apparatus setup state data, measurement data at the above-mentioned parts, that is, alignment measurement data, trace data of mark signal waveform, etc. to the server 61. Further, the main control system 115 controls the operating conditions or stops or suspends the operations based on the control information obtained by the server 61 of the apparatus support system 60 based on the above-mentioned data. Further, the main control system 115 can collect data through the first network 71 forming the communication network 70 from the track 20, laser 30, in-line measuring device 40, off-line measuring devices 50, and other apparatuses. The above concludes the summary of the configuration of the exposure apparatuses 10.

Returning to the exposure apparatus system 1 shown in FIG. 1, each track 20 is a processing system successively transporting wafers along a line and performing the processing in the steps before and after the exposure. The track 20, for example as shown in FIG. 8, has an optimal condition detection unit 25, coating units 21, first bake units 22, second bake units 23, and development units 24. This track 20 uses each coating unit 21 to coat a reflection promoting film, uses each first bake unit 22 to bake it to expel the solvent, and loads the wafers into the exposure apparatus 10 for the exposure processing. After the exposure, it uses each second bake unit 23 for baking (PEB) and uses each development unit 24 for development.

The optimal condition detection unit 25 measures the wafer surface relief, obtains the alignment signal for the input wafers under the same conditions as the exposure apparatus 10, and selects the focus control method and alignment method optimal for the wafers. For this reason, the optimal condition detection unit 25 is provided with an AF system and alignment system the same as the exposure apparatus 10 and thereby detects the conditions for the optimal processing at the exposure apparatus 10. Each track 20 has three of the coating units 21, first bake units 22, second bake units 23, and development units 24 of the same functions and same performances. Further, it processes the input wafers simultaneously in parallel by these units.

Each laser 30 is a light source providing exposure light to the exposure apparatus 10 of each line. Each in-line measuring device 40 is a sensor built into the exposure apparatus 10, track 20, laser 30, or other apparatus, for example, a sensor measuring the temperature, humidity, air pressure, or other information of the apparatus atmosphere. Data measured by the in-line measuring device 40 is output to the server 61 of the apparatus support system 60 based on the later explained data transfer method. Each off-line measuring device 50 is a measurement tool not directly built into a production line of a device and is, for example, an overlay measurement apparatus, line width measurement apparatus, etc.

The apparatus support system 60 collects data from the exposure apparatuses 10, tracks 20, lasers 30, in-line measuring devices 40, off-line measuring devices 50, and various other types of apparatuses through the network 70, analyzes it, and obtains a grasp of for example apparatus abnormalities and other states. Further, when there is an abnormality in an apparatus, it detects the cause based on the analysis results. Further, it controls the processes of the production lines of the exposure apparatus system 1 based on the states of the apparatuses. For this, the server 61 of the apparatus support system 60 first collects data from the exposure apparatuses 10, tracks 20, lasers 30, in-line measuring devices 40, off-line measuring devices 50, and other apparatuses and stores them in a database for management. Further, it uses the stored data to analyze, diagnose, etc. the operating states of the apparatuses or lines. Further, in accordance with need, it deduces the cause of trouble in the apparatuses. Further, based on the results, it performs automatic correction control of the apparatuses, report preparation/notification, and other processing.

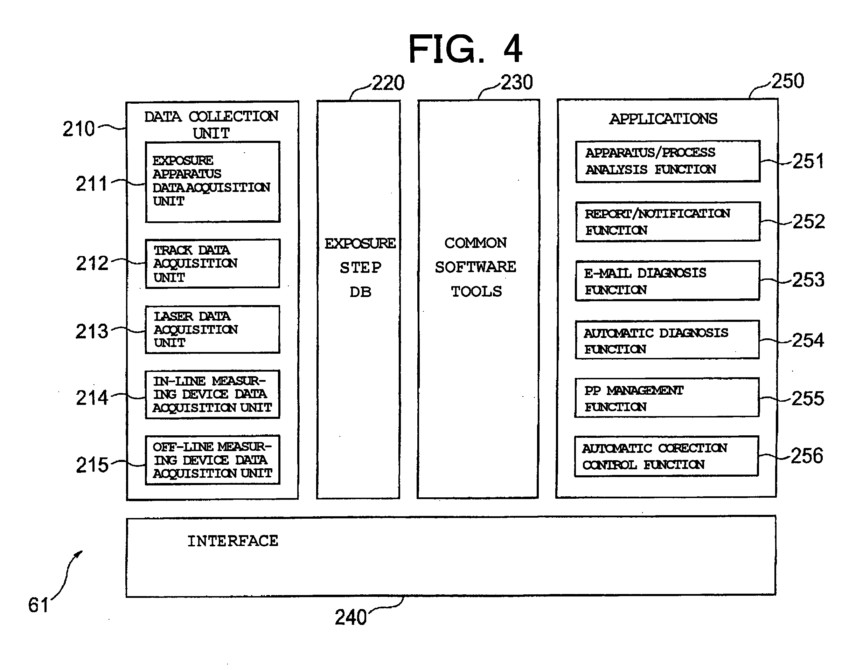

The server 61 of the apparatus support system 60 uses software or hardware for realizing the function modules shown in for example FIG. 4 and executes various apparatus support operations explained later.

The data collection unit 210 of the server 61 has an exposure apparatus data acquisition unit 211 collecting data from the exposure apparatuses 10, a track data acquisition unit 212 collecting data from the tracks 20, a laser data acquisition unit 213 collecting data from the lasers 30, an in-line measuring device data acquisition unit 214 collecting data from the in-line measuring devices 40, and an off-line measuring device data acquisition unit 215 collecting data from the off-line measuring devices 50. These data acquisition units 211 to 215 collect an event log file, sequence log file, error log file, operation history log file, measurement result file, parameter setting file, diagnosis result file, alignment and other various types of signal waveform files, and other various types of trace data or log files etc. from the exposure apparatuses 10 and other apparatuses of the exposure apparatus system 1 through the communication network 70.

The recipe used or the processing unit used for each lot according to the present invention or other information is input through the exposure apparatus data acquisition unit 211 and track data acquisition unit 212. Further, the EGA measurement result data or overlay measurement result data is input through the exposure apparatus data acquisition unit 211 from the exposure apparatuses 10 or through the off-line measuring device data acquisition unit 215 from the off-line measuring devices 50 constituted as overlay error measuring devices.

The exposure step database 220 is a database storing data collected by the data collection unit 210. For example, the recipe used or the processing unit used for each lot or the EGA measurement result data or overlay error measurement data etc. is stored in the exposure step database 220. The data stored in the exposure step database 220 is suitably used in the later explained application 250 and provided for support processing of the exposure apparatuses. Further, it can also be accessed from a later explained terminal apparatus 62 and remote terminal apparatus 63. In general, an exposure apparatus 10 generates a huge amount of data compared with other process apparatuses. The huge amount of data is managed efficiently by the exposure step database 220.

The common software tools 230 are tools used in common when the server 61 performs a desired operation. For example, access to data collected at the data collection unit 210 or data stored in the exposure step database 220, remote connection through the communication network, and other functions are provided as these common tools.

The interface 240 is an interface by which the server 61 communicates with other apparatuses or by which data or commands are input and output with a worker. Specifically, the interface 240 provides a communication environment by which the server 61 is connected through the communication network 70 to exposure apparatuses 10 and other apparatuses for the transfer of data. Further, it provides a remote network connection environment enabling access from a terminal apparatus 62 connected through the communication network 70. Further, it provides a human interface environment for input and output of commands and data from a worker by a suitable form.

The applications 250 are programs in the exposure apparatus system 1 by which the server 61 actually realizes the functions for supporting the exposure apparatuses 10 and other apparatuses. As illustrated, the server 61 of the present embodiment is provided with applications for realizing an apparatus/process analysis function 251, report/notification function 252, e-mail diagnosis function 253, automatic diagnosis function 254, PP management function 255, and automatic correction control function 256.

The apparatus/process analysis function 251 analyzes data stored in the exposure step database 220 and outputs the analysis results in the form of for example a graph. The apparatus/process analysis function 251 performs analysis processing according to the present invention comprised of a process program (recipe) and analysis processing of the dependency of the overlay precision, line width precision, and other exposure characteristics on the processing units of each exposure apparatus 10 and track 20 shown in FIG. 8 and combinations thereof. Note that the specific details of this method of analysis will be explained later.

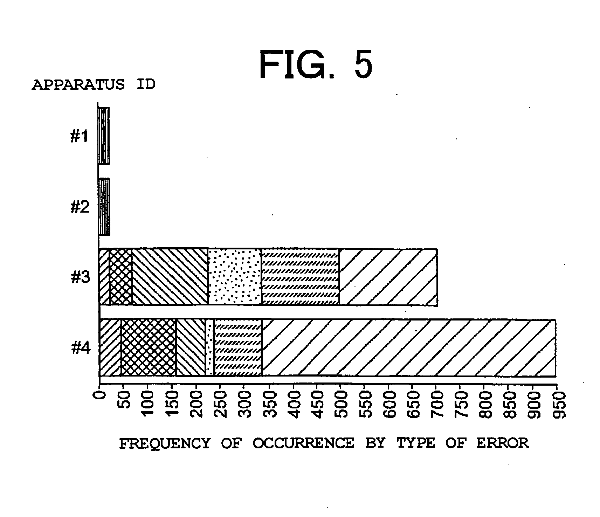

In addition to the analysis processing according to the present invention, the apparatus/process analysis function 251 counts and statistically processes the data stored in the exposure step database 220. For example, the apparatus/process analysis function 251 counts the number of cases of error for each unit of each apparatus and outputs the error count graph such as shown in FIG. 5. The error count graph shown in FIG. 5 is a graph displaying the number of cases of occurrence of error for each exposure apparatus 10 in a predetermined period for each type of error (for each unit of occurrence of error). By viewing this graph, at which unit of which exposure apparatus a problem has arisen can be grasped by a single glance. That is, it is possible to analyze the dependency of error on the apparatuses or recipes (processes/programs) and to shorten the time for dealing with trouble.

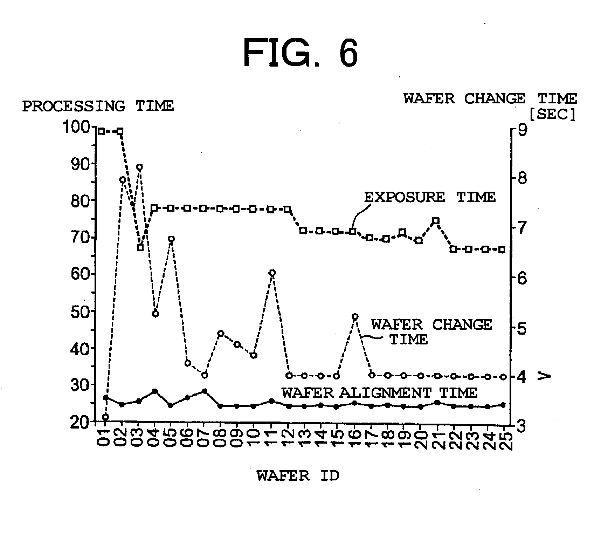

Further, the apparatus/process analysis function 251, for example, counts the processing time for each processing process and outputs a productivity graph as shown in FIG. 6. The productivity graph shown in FIG. 6 is a graph showing wafer exchange time, alignment time, and exposure time for the wafers in a lot. By viewing such a graph, it will be understood that there are sometimes wafers with long wafer exchange times and waste sometimes occurs in wafer transport. That is, from such a graph, the state of utilization of an apparatus can be grasped and measured for improving productivity and efficiency can be studied.

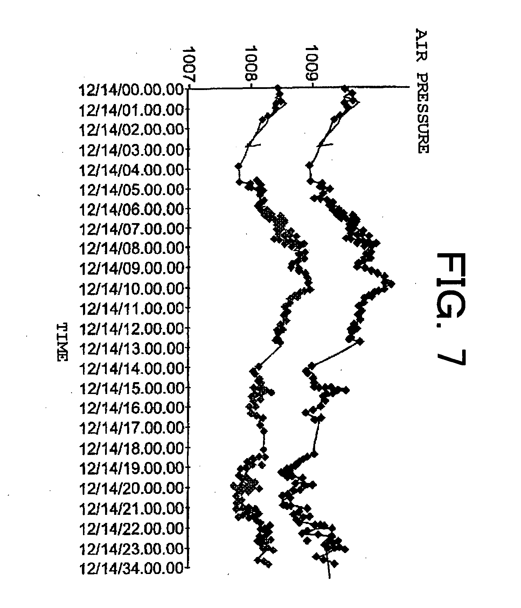

Further, the apparatus/process analysis function 251 for example counts the target air pressures and actual air pressures in the lens chambers and outputs a graph such as shown in FIG. 7 showing the state of control of the air pressure. FIG. 7 plots the target air pressures and measured actual air pressures of two lens chambers (chamber A and chamber B) overlaid. In FIG. 7, the top shows the data relating to the chamber A, while the bottom shows the data relating to the chamber B. The target air pressures are shown by the bent lines, while the actual air pressures are shown by the diamond shapes. By viewing this graph, it will be understood that in both the chamber A and chamber AB, the target air pressure is tracked well. Further, from such a graph, the environment of each exposure apparatus 10 can be grasped. That is, the correlation between apparatus performance and changes in the environment can be found and the time for investigating the causes of process abnormalities can be shortened and the frequency of adjustment of the apparatuses can be optimized.

By the operation of the apparatus/process analysis function 251 in this way, the load when preparing graphs when organizing and analyzing data is lightened. Further, the efficiency of analysis can be improved and the downtime can be shortened.

The report/notification function 252 outputs results of analysis processing or results of deduction of the causes of abnormalities performed by the apparatus/process analysis function 251 etc. through the communication network 70 to for example a terminal apparatus 62 or remote terminal apparatus 63 manned by a worker. Further, the report/notification function 252 automatically generates reports showing the operating state of each apparatus of the exposure apparatus system 1 in units of months, weeks, days, etc. and outputs them to preset predetermined destinations. The contents of the reports are for example MTBF, MTBI, histograms classified by causes of trouble, and other management data for maintaining suitable operating states of the apparatuses.

The e-mail diagnosis function 253 is a function for transmitting the contents of output of the later explained automatic diagnosis function 254 etc. to a remote terminal apparatus 63 at a distant location through the communication network 70. Due to this, it becomes possible for the remote terminal apparatus 63 to monitor the performance, obtain a grasp of trouble and breakdowns, judge the locations of breakdowns, etc. of each apparatus of an exposure apparatus system 1. As a result, diagnosis and adjustment of exposure apparatuses 10 etc. from a remote location becomes possible. Further, by constantly monitoring the operation history or log data, preventive maintenance of apparatuses becomes possible.

The automatic diagnosis function 254 is a function for analyzing the data sent from various types of apparatuses and automatically detecting abnormalities in the operating states of the apparatuses. The automatic diagnosis function 254 also uses the method of analysis according to the present invention to analyze data and deduce causes of abnormality. The method of analysis and method of deducing the cases of abnormalities according to the present invention will be explained in detail later. The automatic diagnosis function 254 additionally performs automatic diagnosis such as diagnosis of the number of cases of error, diagnosis of the maintenance data, and diagnosis of the production data. The diagnosis of the number of cases of error discovers apparatus trouble and defective processes from the number of cases of occurrence of error in the stages, loaders, alignment, etc. of the exposure apparatuses 10. The diagnosis of the maintenance data monitors changes in various types of measurement results in the stages, image forming system, illumination system, alignment, AF, etc. of the exposure apparatuses 10 and optimizes the frequency of maintenance and optimizes the time for replacement of consumables. Further, the diagnosis of the production data monitors the alignment measurement results, focus control data, etc. for early detection of process abnormalities and prevention of production of defective devices. This automatic diagnosis function 254 enables shortening of the downtime and detection of abnormalities early or at a suitable timing and reduction of the reworked wafers.

The recipe (PP) management function 255 is a function for managing recipes describing the actual processing conditions in the exposure apparatuses 10 or other process apparatuses. In the exposure apparatus system 1, the server 61 centrally manages the recipes used for the exposure apparatuses 10 and tracks 20 so that they can be downloaded from the server 61 to the control apparatuses of the exposure apparatuses 10 and tracks or uploaded. Further, the PP management function 255 stores information as to which recipe is used for each lot to control the processing of the exposure apparatuses 10 and tracks 20. This information is referred to when the above-mentioned apparatus/process analysis function 251 analyzes whether the overlay precision or line width precision depends on the recipe.

Further, the PP management function 255 provides an environment enabling a worker to prepare a recipe on the server 61. That is, the PP management function 255 provides an environment and tools etc. enabling a worker to access the server 61 through the communication network 70 from a PC in an office etc. and prepare or edit a recipe (desktop recipe editing function) . Further, the PP management function 255 provides an environment for optimizing the recipe. Normally, a worker edits and optimizes a recipe based on for example the results of analysis or the results of diagnosis by the above-mentioned apparatus/process analysis function 251 or automatic diagnosis function 254. However, when editing a recipe, it is sometimes desirable to check the appropriateness of the other processing conditions. A simulation environment for checking the appropriateness of the conditions is provided by the PP management function 255 to the worker. More specifically, the PP management function 255 provides an environment simulating exposure processing based on the set recipe and due to this enables for example the overlay, focusing, and throughput to be evaluated.

The automatic correction control function 256 is a function which performs feedback or feed forward correction control based on the data sent from the various types of apparatuses for stabilizing the operations of the apparatuses. The automatic correction control function 256 performs automatic correction control when the apparatus/process analysis function 251 performs processing for analysis of the dependency of the overlay precision, line width precision, and exposure characteristics on the recipes and the processing units of the exposure apparatuses 20 or tracks 30 or combinations of the same relating to the present invention and a newly input lot involves the use of a recipe or processing unit having an effect on the overlay precision or line width precision. In this case, the automatic correction control function 256 first instructs the optimal condition detection unit 25 shown in FIG. 8 to detect the optimal conditions. That is, it instructs it to measure the wafer surface relief or obtain an alignment signal for the input wafer under the same conditions as the exposure apparatuses 10 and select the focus control method and alignment method optimal for the wafer. After the optimal processing conditions are selected, the automatic correction control function 256 instructs the exposure apparatuses 10 to perform exposure processing under the selected conditions.

Further, the automatic correction control function 256 performs correction control for changes in environment and states of the apparatuses and correction control for the processes. The correction control for changes in the environment and states of the apparatuses stabilizes the apparatus performance by correction control for changes in temperature, air pressure, humidity, and other aspects of the environment and changes in the state of the exposure apparatuses, tracks, lasers, or other apparatuses. Specifically, for example it performs the following control. First, it predicts and controls the focal plane of an exposure apparatus 10 from the data on the changes in air pressure, temperature, and humidity to improve the planar stability (stabilization of focus over long term). Further, it predicts and controls the optimum amount of exposure from the data on the changes in a laser, air pressure, temperature, and humidity to improve the stability of CD between the wafers (stabilization of ΔCD between wafers). Further, it corrects unevenness of the line width in a wafer due to unevenness of the PEB temperature by finely adjusting the amount of exposure for each shot so as to improve the stability of the ΔCD in the wafer (stabilization of ΔCD in wafer). Further, it measures the changes in temperature at the interface between a loader and track, predicts the wafer expansion/contraction at the time of exposure, and corrects the alignment to improve the overlay precision (stabilization of overlay between wafers).

The correction control for the processes stabilizes the apparatus performance by prediction of the fluctuations due to the processes and changes due to the combination of the exposure apparatus, track, laser, and other apparatuses at the time of operation and correction control of the various operating conditions based on this. Specifically, it performs the following control. For example, it optimizes the correction parameters of SDM (distortion matching) and GCM (grid matching) to improve the overlay precision (improvement of matching overlay precision between apparatuses). Note that for details on the SDM and GCM, see Japanese Patent Publication (A) No. 7-57991 and Japanese Patent Publication (A) No. 2002-353121. Further, it calculates the actual throughput by each recipe (process program) and calculates the actual throughput between an exposure apparatus and track to identify the unit dropped in throughput and assist the measures against it (improvement of productivity by throughput simulator). Further, it automatically selects the alignment measurement algorithm for each process and improves the overlay precision (alignment measurement algorithm automatic measurement). Further, it performs control for correction of the lens aberration optimized for the mask patterns (lens aberration correction control).

Note that the control screen for the functions of the application level is constructed by a web browser to enable all functions to be utilized from anywhere without regard as to being remote or local.

The terminal apparatus 62 of the apparatus support system 60 is for example a terminal apparatus by which a worker accesses the server 61 in a factory. The terminal apparatus 62 is connected to the first network 71 of the communication network 70 and is connected to the server 61 through the first network 71.

The remote terminal apparatus 63 of the apparatus support system 60 is a terminal apparatus by which an interested party accesses the server 61 from for example an office outside the factory or a vendor of the exposure apparatus 10. The remote terminal apparatus 63 is connected through the second network 72, gate apparatus 73, and first network 71 to the server 61 using the function of the interface 240 of the server 61. This concludes the explanation of the configuration of the apparatus support system 60.

The communication network 70 is a network for connecting the apparatuses of the exposure apparatus system 1. The first network 71 of the communication network 70 is for example a communication network in the factory and connects the server 61 and terminal apparatus 62 of the apparatus support system 60, exposure apparatuses 10, tracks 20, lasers 30, in-line measuring devices 40, off-line measuring devices 50, etc. Further, the second network 72 of the communication network 70 is for example a communication network outside the factory, a network managed by the vendor of the exposure apparatus 10, etc. As shown in the drawings, the second network 72 and the first network 71 are connected by for example a gate apparatus 73 having a firewall function.

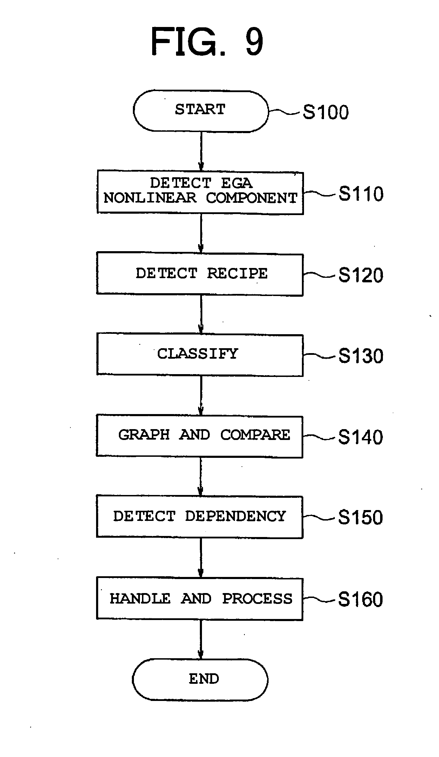

Next, the processing based on the method of analysis of the exposure characteristics dependent on the recipe according to the present invention and the analysis results in this configuration of the exposure apparatus system 1 will be explained with reference to FIG. 8 to FIG. 10. FIG. 9 is a flow chart showing the flow of this analysis processing. This analysis processing counts the nonlinear component of the EGA for each recipe, specifies the recipes with large nonlinear components, and takes countermeasures. The EGA corrects only the linear components. In a wafer with large nonlinear components, the overlay precision deteriorates. Therefore, this processing detects the nonlinear components as the characteristics showing the results of exposure for the analysis. Note that as the reasons for occurrence of EGA nonlinear components, lack of optimization of the sensors or algorithms at the time of alignment, the effects of asymmetry in the alignment marks etc. due to CMP, insufficient precision of temperature management of the wafer, etc. may be mentioned.

This analysis processing is preferably started after using various recipes to expose a certain large number of lots and storing the log information etc. When the analysis processing is started (step S100), it detects and collects the nonlinear components of the EGA for each processed lot (step S110). When the EGA nonlinear components are already detected as overlay error data and for example stored in the exposure step database 220, these may be read out for use. Further, when the alignment measurement data etc. are stored, the function of the apparatus/process analysis function 251 is utilized for extracting the nonlinear components.

Next, the recipe used at the time of track or exposure processing is detected for a lot for which nonlinear components are extracted (step S120). The information of the recipe used is stored in the exposure step database 220 for each lot and therefore is referred to.

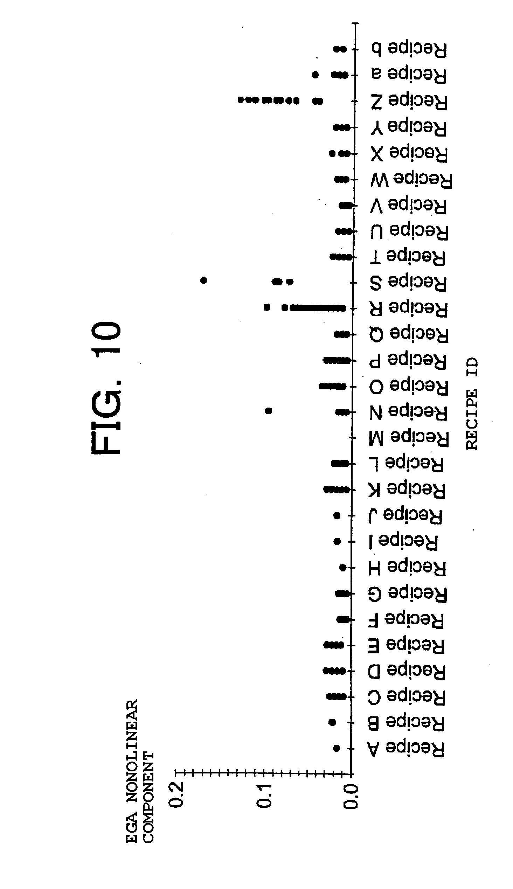

Next, the collected information of the EGA nonlinear components is classified linked with the recipes used (step S130). The classified information of the nonlinear components for the different recipes is graphed to enable easy comparison (step S140). As a result, a graph as shown in for example FIG. 10 is obtained. The graph shown in FIG. 10 plots data of the different lots with the abscissa indicating the exposure recipes and the ordinate indicating the EGA nonlinear components.

Next, whether the EGA nonlinear components are dependent on the recipe is detected (step S150). Specifically, the average value and standard error of the EGA nonlinear components are calculated for each recipe and for example the differences from the average value and standard value calculated for a certain number of recipes are detected. Further, when the differences exceed predetermined threshold values, it is judged that the EGA nonlinear components depend on the recipe. Note that when the operator directly judges the dependency of EGA nonlinear components on a recipe, the operator can easily obtain a grasp of the state of dependency by referring to the graph shown in FIG. 10. From the graph shown in FIG. 10, it is observed that in recipe R, recipe S, and recipe Z, the EGA nonlinear components clearly become greater than in other recipes.

When it is judged that there is dependency, if necessary, predetermined processing to deal with this is performed (step S160). For example, when a recipe judged as affecting the EGA nonlinear components (recipe on which EGA nonlinear components are judged as being dependent) is applied to a new lot, some sort of warning is issued to prompt the operator to investigate it or perform maintenance. For example, the report/notification function 252 is controlled for notification and warning of the same. By issuing such a warning, deterioration of the overlay precision can be prevented in advance.

Further, for example by controlling the automatic correction control function 256 to change the alignment algorithm or activate the GCM (shot array correction function) to correct the shot array up to three dimensions, it is possible to automatically correct any EGA nonlinear components expected to occur. When changing the alignment algorithm, an optimal condition detection unit 25 having a function similar to the FIA in the exposure apparatuses 10 and provided in a track 20 as shown in FIG. 8 utilizes the residence time of the wafer before exposure to identify the algorithmn giving the most suitable alignment waveform in advance. Due to this, it is possible to use the optimal alignment algorithm at the time of exposure. The optimal condition detection unit 25 is provided with a configuration similar to an AF system of the exposure apparatuses 10 and can perform processing to measure the profile of the surface relief in the wafer in the process concerned before exposure and optimize the AF control response in accordance with the measurement results.

By performing such analysis processing, when EGA nonlinear components arise dependent on the recipe, it is possible to easily obtain a grasp of this, analyze them, and take countermeasures. As a result, it becomes easy to optimally set the exposure apparatuses 10 and improve the exposure precision. Note that in the present embodiment, the example of EGA nonlinear components was explained, but similar analysis processing can be applied to the EGA linear components. The EGA linear components originally should be corrected by the EGA measurement, but if the wafer expands or contracts between the time of EGA measurement and the time of exposure, the linear components end up being left in the results of exposure. These becomes overlay error. Therefore, the above-mentioned analysis processing may also be applied to the EGA linear components to detect the dependency between the residual linear error and recipe. Further, when using a recipe with dependency for exposure, the offset obtained from the analysis results may be added to the EGA measurement results for the exposure. This enables the exposure apparatuses 10 to be improved in exposure precision.

Such a method of analysis can also be used for analysis in the case where the exposure characteristics fluctuate depending on the processing units used in the exposure apparatuses 10 and tracks 20 and their combinations. For example, assume that, as shown in FIG. 8, an exposure apparatus 10 and track 20 both include pluralities of processing units having the same functions. In the case of FIG. 8, there are 324 (=34x22) combinations of units through which a wafer actually passes. Therefore, by focusing on a specific recipe, using a method similar to the above-mentioned method to calculate for example the variations in line width for a large number of wafers processed by this recipe, and classifying them linked with combinations of processing units, it is possible to detect the dependency of variations in line width on different combinations of processing units. That is, it is possible to easily detect combinations of processing units affecting variations in line width.

In this case as well, when a wafer arrives by a combination of processing units where the variations in line width tend to become larger, it is possible to issue a warning and prompt the operator to take countermeasures before exposure, after the end of development, etc. to prevent greater production of defects. Further, if measuring the distribution of line widths for each combination of processing units, it is possible to use the ODC function at the time of exposure (function for deliberately changing the evenness of illumination and control of the amount of exposure for each shot to improve the uniformity of line width) to perform the optimal correction of exposure for the corresponding combination of units.

In this way, the exposure apparatus system 1 of the present embodiment can pick up the state of the exposure apparatuses 10 and abnormal conditions quickly at the server 61, easily and suitably analyze the data, and for example deduce causes of abnormalities etc. In particular, it can easily analyze the effects of a recipe or a processing unit or combinations thereof on the line width or overlay precision, detect the dependencies, and take countermeasures. Therefore, it is possible to take suitable steps against occurrence of abnormal states, easy to optimally set the exposure apparatuses, improve the exposure precision, and produce high performance electronic devices with a good productivity.

Note that in the present embodiment, the example of using the server 61 forming the apparatus support system 60 to perform processing for analysis of the dependency of the exposure characteristics on the process program and processing units of the exposure apparatuses 10 and tracks 20 and their combinations, but the present invention is not limited to these. For example, the main control apparatus 115 provided in each exposure apparatus 10 may also collect the necessary information through the communication network 70 and perform analysis similar to the above. In this case, the collecting means collecting the information and the analyzing means analyzing it are realized by hardware and software of the main control apparatus 115 working together.

Note that the present embodiment was explained for facilitating the understanding of the present invention and does not limit the present invention in any way. The elements disclosed in the present embodiment includes all design modifications and equivalents falling under the scope of technology of the present invention and can be modified in any suitable way. For example, the present invention is not limited to a system including exposure apparatuses. It may also be applied to any processing apparatuses used in the process of production of electronic devices.

This disclosure relates to matter contained in Japanese Patent Application No. 2004-133600 filed on April 28, 2004 and clearly incorporates all of that disclosure here by reference.

## Claims

1. A method of analysis comprising:
detecting predetermined characteristics of results of exposure obtained by exposure of an exposure object,
detecting process programs defining conditions of predetermined processing of a lithography step including said exposure performed on said exposure object,
classifying the detected predetermined characteristics of results of exposure for each said process program, and
detecting dependency of said predetermined characteristics of results of exposure on said process programs.

2. The method of analysis as set forth in claim 1, further comprising:
detecting a processing unit or combination of processing units used for predetermined processing of said lithography step performed on said exposure object,
classifying said detected predetermined characteristics of results of exposure for each said process program, said processing unit, said combination of processing units, or combination thereof, and
detecting dependency of said predetermined characteristics of results of exposure on each said process program, said processing unit, said combination of processing units, or combination thereof.

3. The method of analysis as set forth in claim 1, wherein said predetermined characteristics of results of exposure are a precision of line width of patterns formed by exposure and an overlay precision of said patterns.

4. The method of analysis as set forth in claim 2, further comprising:
specifying at least one of said process program, said processing unit, said combination of processing units, or combination thereof where said predetermined characteristics of results of exposure are predicted to exceed predetermined reference values based on said detected dependency and
issuing a warning when processing relates to said specified process program, processing unit, combination of processing units, or combination thereof.

5. A method of analysis comprising:
detecting predetermined characteristics of results of exposure obtained by exposure of an exposure object,
detecting processing units or combinations of processing units used for predetermined processing of a lithography step performed on said exposure object,
classifying said detected predetermined characteristics of results of exposure for each said processing unit or combination of processing units, and
detecting dependency of said predetermined characteristics of results of exposure on each said process program.

6. An exposure apparatus comprising:
an exposing portion for exposing patterns formed on a mask onto a substrate,
a detector for detecting predetermined characteristics of results of exposure of said patterns,
a collecting portion for collecting process programs defining conditions of processing used in predetermined processing of a lithography step including said exposure, processing units information or combinatorial information of said processing units used in said predetermined processing of said lithography step or their combinations, and
an analyzing portion for classifying said predetermined characteristics of results of exposure detected by said detecting portion for each of said process programs, said processing units, said combinations of processing units, or their combinations collected by said collecting portion and analyzing dependency of said predetermined characteristics of results of exposure on said process programs, said processing units, said combinations of processing units, or combinations thereof.

7. The exposure apparatus as set forth in claim 6, wherein said analyzing portion issues warning that a substrate to be exposed is a substrate on which a process program, processing unit, combination of processing units, or their combination which would have an effect on the predetermined characteristics of results of exposure is used when this is the case.

8. The exposure apparatus as set forth in claim 6, wherein said exposing portion performs exposure along with correction processing for eliminating effects on said predetermined characteristics when the substrate to be exposed is a substrate on which a process program, processing unit, combination of processing units, or their combination which would have an effect on the predetermined characteristics of results of exposure is used.

9. A exposure apparatus system comprising:
a track having processing units for performing predetermined processing of steps before and after exposure on a substrate used for exposure,
an exposure apparatus for transferring patterns formed on a mask to a predetermined shot area of a substrate by exposure processing,
a collecting portion for collecting process programs defining conditions of processing used in predetermined processing of a lithography step including said exposure for said substrate used for said exposure, processing units or combinations of processing units used in said predetermined processing of said lithography step, or their combinations, and
an analyzing apparatus for classifying said predetermined characteristics of results of exposure for each of said process programs, said processing units, said combinations of processing units, or their combinations collected by said collecting portion and analyzing dependency of said predetermined characteristics of results of exposure on said process programs, said processing units, said combinations of processing units, or combinations thereof.

10. The exposure apparatus system as set forth in claim 9, wherein
said track further has an optimal condition detecting portion for detecting control conditions for processing of a substrate, on which a process program, processing unit, combination of processing units, or their combination which would have an effect on the predetermined characteristics of results of exposure is used, by said exposure apparatus so that said predetermined characteristics are not affected, and
said exposure apparatus performs exposure by said control conditions detected by said optimal condition detecting portion when the substrate to be exposed is a substrate on which a process program, processing unit, combination of processing units, or their combination which would have an effect on the predetermined characteristics of results of exposure is used.

11. The exposure apparatus system as set forth in claim 10, wherein said optimal conditions detecting portion measures surface relief of said substrate and detects said control conditions for focus control.

12. An exposure apparatus system as set forth in claim 10, wherein said optimal conditions detecting portion observes patterns formed on said substrate and detects said control conditions for detection of the positions of said patterns.
